# EUROPÄISCHE PATENTSCHRIFT

(11) **EP 1 422 983 B1**
(45) Veröffentlichungstag und Bekanntmachung des Hinweises auf die Patenterteilung: **18.07.2018**
(21) Anmeldenummer: 03023036.1
(22) Anmeldetag: 13.10.2003
(51) Int. Cl.: H05K 7/20

(54) **Trittfestes, wärmeableitendes und -abstrahlendes Kunststoffgehäuse mit Kühl-/Tragrippen und umspritztem Kühlkörper und Verfahren zu dessen Fertigung**
Wear resistant , heat conductive , heat radiating , plastic housing provided with supporting fins and overmolded heat sink for cooling, method of manufacturing the same
Boîtier plastique résistant à l'usure, conduisant et rayonnant la chaleur, pourvu de nervures de renfort et d'un radiateur surmoulé pour le refroidissement, procédé de fabrication de ce boîtier

(30) Priorität: 14.10.2002 DE 10247828
(43) Veröffentlichungstag der Anmeldung: 26.05.2004
(73) Patentinhaber: iAd Gesellschaft für Informatik, Automatisierung und Datenverarbeitung mbH, 90613 Grosshabersdorf (DE)
(72) Erfinder: Hampel, Hermann, Dipl.-Ing., 90613 Grosshabersdorf (DE)
(74) Vertreter: Dreykorn-Lindner, Werner

(56) Entgegenhaltungen:
- EP-A- 0 757 384
- DE-A1- 3 933 123
- DE-A1- 10 014 457
- GB-A- 2 256 531

## Beschreibung

Die Erfindung betrifft in erster Linie ein Gehäuse, welches zwei Gehäuse-Kunststoffschalen und einen im Gehäuse angeordneten Kühlkörper aufweist (Patentanspruch 1). Weiterhin betrifft die Erfindung ein Verfahren zur Herstellung des Gehäuses nach Anspruch 1 (Patentanspruch 9).

Gehäuse für elektronische Schaltungen, die Umwelteinflüssen ausgesetzt sind, müssen dicht schließen. Bei der Auslegung des Gehäuses ist darauf zu achten, dass die von den Bauelementen, beispielsweise einer Leistungsstufe, erzeugte Verlustwärme in einem derartigen Maße abgeführt wird, dass keine unzulässige Erwärmung stattfindet.

Um ein Gehäuse verfügbar zu machen, das bei kleinem kompakten Aufbau die Aufnahme von elektrischen und/oder elektronischen Schaltungen mit relativ hoher Verlustwärme ohne deren Gefährdung durch Wärmestau ermöglicht, ist beispielsweise aus dem G 88 15 604.4 ein Gehäuse mit einem Gehäuseboden bekannt, welcher wenigstens teilweise direkt als Kühlkörper mit einem Kühlprofil ausgebildet ist. Da die entstehende Wärme direkt nach außen abgeführt wird, bildet sich im Gehäuseinnern kein unerwünschter Wärmestau aus, der empfindliche Bauteile gefährden könnte. Der Kühlkörper besteht aus einem wärmeleitenden Material, vorzugsweise aus Aluminium. Der Gehäuseboden mit dem Kühlkörper sitzt direkt auf einer üblicherweise metallisch ausgebildeten Montage- bzw. Tragschiene auf, so dass nicht nur eine Wärmeableitung durch Konvektion über das Kühlprofil, sondern auch zusätzlich eine Wärmeableitung über die Tragschiene erfolgt. Um eine zusätzliche Verbesserung der Wärmeableitung vom Gehäuseinnern zu der Gehäusebodenaußenseite zu realisieren, weist der Gehäuseboden wenigstens im Bereich der Kühlprofilabschnitte Montagebohrungen auf, die für den Eingriff von ebenfalls gut wärmeleitenden Befestigungsmitteln, wie Schrauben oder dergleichen vorgesehen sind.

Ein ähnlicher Weg ist bei der aus der DE 100 13 844 A1 bekannten Vorrichtung zum Kühlen eines elektrischen Moduls eingeschlagen worden. Um die Wärmeabfuhr zur Kühlung von elektronischen oder elektrischen Bauteilen und ganzen Baugruppen/Modulen zu verbessern, ist auf dem/den Modul(en) ein aus Kunststoff gebildeter Kühlkörper befestigt, wobei zur Optimierung der physikalischen Eigenschaften des Kühlkörpers, insbesondere hinsichtlich der Wärmeleitfähigkeit und/oder des Wärmeausdehnungskoeffizienten, in den Kunststoff ein Füllstoff, beispielsweise Kohlenstofffasern und/oder ein Metallgranulat, eingelagert ist. Kohlenstofffasern besitzen Wärmeleitfähigkeiten, die größer als 1000 W/mK sein können. Im Vergleich dazu besitzen die Metalle, aus denen metallische Kühlkörper gebildet werden, wesentlich geringere Wärmeleitfähigkeiten. Die Wärmeleitfähigkeit für Aluminium beträgt beispielsweise ca. 200 W/mK. Für Kupfer und CuW 85/15 beträgt die Wärmeleitfähigkeit 380 W/mK bzw. 230 W/mK. Mit Hilfe der Abstimmung des Verhältnisses, beispielsweise hinsichtlich Gesamtmasse der eingelagerten Kohlenstofffasern und der Metallgranulate zueinander, können die physikalischen Eigenschaften an den Kühlbedarf des jeweiligen Moduls angepasst werden, für welches der Kühlkörper genutzt wird. Als Material für das Metallgranulat ist beispielsweise Kupfer geeignet. Schließlich weist der Kühlkörper zur Vergrößerung seiner äußeren Gesamtoberfläche Kühlrippen auf, so dass die von den Bauelementen auf den Kühlkörper übergegangene Wärme besser an die Umgebung des Kühlkörpers abgegeben werden kann.

Ein ähnlicher Weg, um ein Gehäuse mit geringer Bauhöhe in Kombination mit der Realisierung einer effizienten Wärmeableitung der von den Leistungsbaüelementen erzeugten Wärme herzustellen, ist aus der DE 199 53 191 A1 für ein Steuergerät bekannt. Das Gehäuse wird durch einen beidseitig offenen Gehäuserahmen gebildet, dessen offene Unterseite mit einer das Bodenteil des Gehäuses bildenden metallischen Wärmesenke abgedeckt wird, wobei die in dem Gehäuse angeordneten Leistungsbauelemente auf ihrer von der Leiterplatte abgewandten als Kühlfläche vorgesehenen Seite mit der Wärmesenke kontaktiert sind. Kontaktelemente der Steckerteile und hochstromführende Leiterstreifen werden in einfacher Weise durch ein Stanzgitter gebildet, welches durch Spritzgießen in den Gehäuserahmen eingebettet werden kann. Die Anschlüsse der Leistungsbauelemente können mit Leiterbahnen der Leiterplatte und/oder mit nicht in Kunststoff eingebetteten Abschnitten des Stanzgitters kontaktiert werden. Weiterhin ist vorgesehen, dass der Gehäuserahmen mit Querstegen versehen ist, an welchen Haltemittel für die Leistungsbauelemente und/oder Haltemittel für weitere elektrische Bauelemente ausgebildet sind. Hierdurch wird erreicht, dass nicht alle Bauelemente auf die Leiterplatte aufgebracht werden müssen und große Bauelemente, welche viel Platz beanspruchen, unabhängig von der Leiterplatte an den Haltemitteln des Gehäuserahmens festgelegt werden können. Durch diese Maßnahme wird die Bauhöhe der Anordnung stark reduziert. Außerdem wird durch die Querstege ein sehr stabiler Aufbau in Verbindung mit einer erleichterten Montage realisiert. So können beispielsweise große Kondensatoren an dem Gehäuserahmen vormontiert werden und anschließend die Leiterplatte an dem Gehäuserahmen festgelegt werden. Ein besonders guter Schutz gegen Feuchtigkeit und Umwelteinflüsse kann dadurch realisiert werden, dass das aus Gehäuserahmen, metallischem Bodenteil und Deckelteil gebildete Gehäuse ein hermetisch dicht verschlossenes Gehäuse ist. Ergänzend hierzu ist die Oberseite und/oder Unterseite des Gehäuserahmens mit einer umlaufenden Dichtung versehen, auf welche das Deckelteil und das Bodenteil aufgelegt werden. Die kompakte, flache Bauweise kann noch dadurch verbessert werden, dass das metallische Bodenteil mit wenigstens einer Versenkung und/oder wenigstens einem Podest zur Anlage der Leistungsbauelemente und/oder der weiteren elektrischen Bauelemente versehen ist.

Um eine schmale Bauform für eine elektrische Baueinheit mit einem Kühlkörper, einem mit dem Kühlkörper verbundenen Leistungsblock und mit einer Leiterplatte zur Aufnahme und Verschaltung elektronischer Bauelemente zu realisieren, ist es aus dem G 87 04 499.4 bekannt, den Kühlkörper L-förmig auszubilden, wobei seine beiden Innenflächen Gehäusewandungen sind. Der L-förmige Ausschnitt des Körpers bildet selbst das Gehäuseinnere, wobei die mit Kühlrippen versehenen Außenseiten des Kühlkörpers direkt der Umgebungsluft ausgesetzt sind. Der L-förmige Ausschnitt des Kühlkörpers lässt sich in einfacher Weise zur Vervollständigung des Gehäuses durch eine L-förmige Abdeckhaube (geschlossenes Gehäuse durch jeweils weitere Gehäusewandung) abdecken. Die Leiterplatte wird dabei über Anschlussbolzen mechanisch und elektrisch mit dem Leistungsblock verbunden und über Nuten und Ansätze wird eine formschlüssige Verbindung zwischen der Abdeckhaube und dem Kühlkörper hergestellt.

Weiterhin ist aus der DE 39 33 123 A1 ein Gehäuse für eine elektronische, mit Anschlussstecker versehene Schaltung, mit einem Rahmen, an dem eine die elektronische Schaltung aufweisende Leiterplatte befestigt ist und mit einem Kühlkörper, dem Leistungs-Bauelemente der elektronischen Schaltung zugeordnet sind, sowie mit einer die Leiterplatte umfangenden Abdeckung bekannt. Um eine einfache, kostengünstige Ausbildung eines dicht schließenden Gehäuses zu ermöglichen, das gute Wärmeableiteigenschaften für wärmeerzeugende Bauelemente aufweist, ist im einzelnen ein gespritzter Kunststoffrahmen vorgesehen, in den mindestens ein Wärmeleitsteg wenigstens eines Kühlkörpers eingeformt ist. Bei der Herstellung wird der Wärmeleitsteg im Kunststoffspritzverfahren eingebettet, so dass eine spaltfreie und dichte Ausbildung gewährleistet ist. Das eine Ende des Wärmeleitstegs geht in eine im Gehäuseinneren liegende Bauelement-Montagefläche über und das andere Ende des Wärmeleitstegs ist als außerhalb des Gehäuses liegendes Wärmeabführelement ausgebildet. Die von auf der Bauelement-Montagefläche angeordneten Bauelementen erzeugte Wärme wird daher direkt über den eingebetteten Wärmeleitsteg aus dem Gehäuseinneren herausgeführt, so dass gute Kühleigenschaften vorliegen. Außerhalb des Gehäuses erfolgt eine Wärmeableitung durch das Wärmeabführelement, wobei vorzugsweise eine Einstückigkeit zwischen Bauelement-Montagefläche, Wärmeleitsteg und Wärmeabführelement vorliegt, so dass sehr kleine Wärmeübergangswiderstände vorliegen. Trotz eines dicht schließenden Gehäuses ist auf die genannte Art und Weise eine effektive Wärmeabfuhr gewährleistet. Der Kunststoffrahmen stellt dabei eine einfache und kostengünstige Lösung dar und der Kühlkörper besteht vorzugsweise aus Metall. Eine Doppelfunktion wird vom Wärmeabführelement übernommen, wenn dieses gleichzeitig als Gehäuse-Befestigungsanschluss ausgebildet ist. Überdies werden hierdurch die Wärmeableiteigenschaften noch weiter verbessert, da über die Befestigung die vom Wärmeleitsteg transportierte Wärme aufgenommen bzw. weitergeleitet wird, so dass Wärmestaus vermieden sind. Da die elektronische Schaltung an Versorgungs- und Datenleitungen angeschlossen werden muss, ist ein Anschlussstecker vorgesehen. Dieser lässt sich dadurch am Gehäuse festlegen, in dem er in den Kunststoffrahmen eingeformt ist. Mithin wird bei der Rahmenherstellung nicht nur der Wärmeleitsteg des Kühlkörpers, sondern auch der Anschlussstecker mit Kunststoff umspritzt. Damit ist auch beim Anschlussstecker ein spaltfreier Übergang zum Kunststoffrahmen garantiert. Die Abdeckung ist vorzugsweise von zwei Gehäuse-Kunststoffschalen gebildet, die mit der Ober- und Unterseite des Kunststoffrahmens verbunden, vorzugsweise, verschweißt, sind. Durch die Verschweißung ist auf besonders einfache Weise ein dicht schließendes Gehäuse realisiert. Um eine hohe elektromagnetische Verträglichkeit (EMV) zu erzielen, so dass weder von der elektronischen Schaltung eine Störabstrahlung nach außen, noch eine Störeinstrahlung nach innen erfolgen kann, sind die Gehäuse-Kunststoffschalen vorzugsweise metallisiert.

Um einen Kühlkörper so auszubilden, dass eine möglichst große Gestaltungsvielfalt mit Blick auf das Gehäuse zur Aufnahme der Schaltung möglich ist, ist aus der DE 100 14 457 A1 ein Kühlkörper mit einem Gehäuse für eine wärmeabgebende elektronische Schaltung bekannt, bei dem zumindest die Seitenwandungen des Gehäuses aus Kunststoff bestehen und durch Umspritzen des oberen Abschnitts des Kühlkörpers fest mit diesem verbunden sind. Durch diesen Aufbau wird eine Trennung der Funktionen erreicht, nämlich- die Kühlung durch den in der Regel metallischen Kühlkörper einerseits und die Halterung der elektronischen Schaltung durch das Gehäuse aus dem umspritzten Kunststoff andererseits. Die Herstellung eines Gehäuses aus Kunststoff mittels Umspritzen des Kühlkörpers bietet eine große Gestaltungsvielfalt, ohne dass mechanische Nachbearbeitungen erforderlich werden. Im einzelnen ist vorgesehen, dass die Oberseite des metallischen Kühlkörpers nach wie vor zumindest teilweise frei bleibt, so dass der wärmeleitende, Kontakt zu der elektronischen Schaltung ohne weiteres hergestellt werden kann. Es kann weiterhin vorgesehen werden, dass der Kunststoff des Gehäuses zumindest teilweise den der Schaltung zugekehrten Boden des Kühlkörpers abdeckt. Dadurch kann eine Isolationsschicht unmittelbar beim Herstellen des Gehäuses vorgesehen werden, so dass Kurzschlüsse, Kriechströme oder dergleichen vermieden werden können. Insbesondere ist es möglich, dass der Kunststoff lediglich die zur Wärmeübertragung erforderliche metallische Oberfläche des Kühlkörpers frei lässt. Weiterhin ist vorgesehen, dass das Gehäuse zumindest teilweise entlang dem Umfang über zumindest einen Teil der Höhe der Seitenwandung doppelwandig unter Bildung einer inneren Wanne ausgebildet ist. In dieser inneren Wanne kann die elektronische Schaltung besonders gut geschützt gegen äußere Einflüsse montiert sein. Insbesondere ist es möglich, dass in der zusammengebauten Lage die innere Wanne die Schaltung aufnimmt und mit einem Weichverguss, beispielsweise aus Silikon, verfüllt ist. Das Gehäuse selbst kann beispielsweise durch einen Deckel verschlossen sein. Dadurch wird erreicht, dass der gegen Druck relativ empfindliche Weichverguss gegen mechanische Einflüsse geschützt ist. Zusätzlich kann in der zusammengebauten Lage das Gehäuse mit einer Hartvergussmasse verfüllt werden. Die Hartvergussmasse kann sich bis in den durch die doppelte Wandung gebildeten Spalt erstrecken und dort verankert sein. Im einzelnen ist die Anordnung in der zusammengebauten Lage demnach so getroffen, dass in der inneren Wanne des doppelwandigen Gehäuses die elektronische Schaltung in einer Weichvergussmasse eingebettet ist. Die anschließend eingebrachte Hartvergussmasse deckt die Weichvergussmasse ab und wird gleichzeitig in dem Spalt zwischen den doppelten Wandungen fest verankert. Dadurch wird erreicht, dass ein Druck auf die Hartvergussmasse unmittelbar in das Gehäuse eingeleitet wird, ohne auf die Weichvergussmasse zu wirken. Der Kühlkörper kann grundsätzlich aus einem beliebigen wärmeleitenden Material bestehen. Es ist jedoch zweckmäßig, wenn der Kühlkörper ein Aluminiumdruckgussteil oder ein Aluminiumfließpressteil ist.

Weiterhin ist aus der DE 199 29 209 A1 ein elektronisches Steuergerät mit einem auf einem Schaltungsträger mit Leistungsbauteil angeordneten Kühlkörper bekannt. Hierzu ist im einzelnen ein metallischer Kühlkörper, der unter dem Leistungsbauteil auf die dem Leistungsbauteil abgewandte Seite des Schaltungsträgers gelötet ist und eine Länge von höchstens 40 mm, eine Breite von höchstens 40 mm und eine Dicke von höchstens 5 mm aufweist, eine Kunststoffmasse in die der Kühlkörper formschlüssig eingebettet ist und wenigstens eine Durchkontaktierung des Schaltungsträgers, die einen thermischen Pfad zwischen dem Leistungsbauteil und dem Kühlkörper bereitstellt, vorgesehen. Durch die gute thermische Kopplung zwischen dem Leistungsbauteil und dem Kühlkörper wird bei einer momentan auftretenden hohen Verlustleistung die Wärme sehr effizient in den Kühlkörper abgeleitet. Über die Kunststoffmasse, die ein Vielfaches der Masse des Kühlkörpers aufweist, erfolgt eine Pufferung und Abführung der aufgenommenen Wärme. Der metallische Kühlkörper sorgt also für die schnelle Ableitung von Wärme in die Kunststoffmasse. Letztere weist regelmäßig eine höhere Wärmekapazität auf als das üblicherweise für Wärmesenken verwendete Aluminium.

Die wärmeableitende Befestigung mindestens eines elektronischen Bauelements direkt über einen aus Kunststoff bestehenden Träger ist aus der DE 39 16 899 A1 bekannt. Der Träger bildet die Grundplatte,einer elektronischen Schaltung und hat dabei eine Doppelfunktion, indem er einerseits der Wärmeableitung und andererseits als Substrat für die elektronische Schaltung dient. Bildet die Grundplatte den Boden eines Gehäuses für die elektronische Schaltung, so leitet der Boden des Gehäuses die entstehende Verlustwärme des auf seiner Innenseite angeordneten elektronischen Bauelements oder dergleichen ab, wobei die Anordnung derart ausgebildet ist, dass das Gehäuse im montierten Zustand die Verlustwärme einer Montagefläche (Chassis- oder Karosserieteil des Kraftfahrzeuges) zuführt. Die Wärmeableitung wird dadurch verbessert, dass das Bauelement in einer Vertiefung des Trägers angeordnet ist. Alternativ oder auch zusätzlich kann mindestens ein eingespritztes oder eingelegtes, ein Teil des Trägers bildendes Wärmeabführelement vorgesehen werden. Dieses Wärmeabführelement besteht insbesondere aus Metall oder aber auch - für eine elektrische Isolierung - aus Aluminiumnitrid. Das in den Träger eingespritzte oder eingelegte Wärmeabführelement verbessert die Wärmeabfuhr. Es wird ein "kanalisierter" Wärmefluss hin zur Wärmesenke (z. B. Chassis oder Karosserie) erzeugt, wobei das Wärmeabführelement mit seiner dem elektronischen Bauteil abgewandten Seite einen Teil der Außenfläche des Bodens bildet. Über das in den Kunststoffboden des Gehäuses eingebettete Wärmeabführelement kann ein Größteil der Verlustwärme dann direkt zur Montagefläche abgeleitet werden, wobei das Wärmeabführelement direkt den Umwelteinflüssen ausgesetzt ist.

Um eine elektronische Vorrichtung mit einem zweiteiligem Kunststoffgehäuse zur Aufnahme eines, eine elektronische Schaltung tragenden Trägersubstrates, anzugeben, welche die elektronische Schaltung zuverlässig gegen Feuchtigkeit schützt, ist es aus der DE 198 55 389 A1 bekannt, eine metallische Wärmeleiteinrichtung an dem ersten Gehäuseteil anzuordnen, auf deren in das Gehäuseinnere weisenden Seite das die elektronische Schallung tragende Trägersubstrat befestigt ist. Dabei kann die metallische Wärmeleiteinrichtung eine, über die Außenfläche des ersten Gehäuseteiles hinausragende, rippenähnliche Struktur aufweisen und ist ebenfalls direkt den Umwelteinflüssen ausgesetzt. Um die Wärmeableitung von der Elektronik auf die Wärmeleiteinrichtung gezielt zu ermöglichen, liegt mindestens ein Teil des Trägersubstrates unmittelbar auf der in das Gehäuseinnere weisenden Seite der Wärmeleiteinrichtung auf. Dabei wird der Wärmeübergang vorn Trägersubstrat an die Wärmeleiteinrichtung entweder durch eine elektrisch isolierte Schraubverbindung oder durch ein Wärmeleitmedium unterstützt, welches das Trägersubstrat mit der Wärmeleiteinrichtung verklebt.

Weiterhin ist aus der DE 25 11 010 A1 ein elektrisches Bauelement bekannt, dessen spannungsführende Bereiche mit einer Isolationsschicht abgedeckt sind und das zur Wärmeabführung einen Kühlkörper aus einem gut wärmeleitenden Material mit großer Oberfläche aufweist. Um die Wärmeabführung bei elektrischen Bauelementen und insbesondere bei mehreren mit einer gedruckten Schaltung kontaktierten elektrischen Bauteilen mit einem möglichst einfach herstellbaren Kühlkörper ohne Verwendung eines teueren massiven Metallkörpers zu ermöglichen, ist im einzelnen vorgesehen, dass der Kühlkörper aus einer Pressmasse besteht, die mit wärmeleitendem Metall durchsetzt ist. Das Metall besteht dabei vorzugsweise aus einem Eisenpulver und die Pressmasse aus einem aushärtbaren Kunststoff. Der Kühlkörper kann mit mehreren, nach vorn gerichteten, parallel verlaufenden Kühlrippen versehen werden, durch die die Oberfläche des Kühlkörpers zur Abführung der Wärme an die ihm umgebende Luft wesentlich vergrößert ist. Auch hier ist der Kühlkörper, welcher quasi das Gehäuse für das elektrische Bauelement bzw. die gedruckte Schaltung bildet, direkt den Umwelteinflüssen ausgesetzt.

Ein elektronisches Modul mit Leistungsbauelementen, einem Kühlkörper, einem Schutzgehäuse mit Außenanschlüssen, und mit Mitteln zur Bewirkung einer Flächenpressung zwischen den Leistungsbauelementen und einer Wärmekontaktfläche des Kühlkörpers ist aus der DE 195 33 298 A1 bekannt. Um einen montagefreundlicheren Modulaufbau zu schaffen, ist das Schutzgehäuse hutartig auf den Außenrand des Kuhlkörpers aufsetzbar, auf dessen zum Schutzgehäuse weisender Wärmekontaktfläche die Leistungsbauelemente aufliegen. Das Schutzgehäuse besteht aus Kunststoff und weist integrierte Klemm- und Rastbereiche auf und der Außenrand des Kühlkörpers ist so ausgebildet, dass durch Aufsetzen des Schutzgehäuses ein ringförmiger Kraft- und Formschluss zwischen dem Schutzgehäuse und dem Kühlkörper herstellbar ist. Mit dem Aufsetzen ist gleichzeitig die Flächenpressung durch zwischen den Leistungsbauelementen und dem aufgesetzten Schutzgehäuse angeordnete Kraftschlusselemente bewirkt. Die Kraftschlusselemente weisen in vertikaler Richtung eine hohe bleibende Rückstellkraft auf, so dass sich nach dem Aufsetzen und Verrasten der beiden Modulteile eine Flächenpressung mit für die Kühlung ausreichend gutem Wärmeübergang ergibt. Sofern die Wärmekontaktfläche nicht bereits sehr eben ist, ist es möglich, als Ausgleichsmedium eine Schicht aus Kleber oder Wärmeleitpaste vorzusehen. Ebenso möglich ist eine duktile Metallfolie. Schließlich können auch spritztechnisch mit dem Schutzgehäuse verbundene, d.h. integrierte Kraftschlusselementen aus elastomer modifiziertem Thermoplast vorgesehen werden. Auch hier ist der Kühlkörper, welcher quasi einen Gehäuseteil für Leistungsbauelemente bildet, direkt den Umwelteinflüssen ausgesetzt.

Eine elektronische Einrichtung für ein Kraftfahrzeug, mit einem zweiteiligen Gehäuse, bei dem eine großflächig ausgebildete Kondensatoreinheit wärmetechnisch mit einem ersten Gehäuseteil und eine Elektronikeinheit wärmetechnisch mit einem zweiten Gehäuseteil verbunden sind, ist aus der DE 198 57 840 A1 bekannt. Zur Stabilisierung der Lage der Kondensatoreinheit ist diese durch ein, sich an dem zweiten Gehäuseteil abstützendes Federelement gegen das erste Gehäuseteil vorgespannt. Dabei kann zwischen der Kondensatoreinheit und dem ersten Gehäuseteil eine Wärmeleitkleberschicht angeordnet sein und die Elektronikeinheit liegt zur wärmetechnischen Kopplung flächig auf dem zweiten, plattenähnlich gestalteten Gehäuseteil auf. Das erste Gehäuseteil kann zur formschlüssigen Aufnahme der die Kondensatoreinheit bildenden einzelnen Kondensatorelemente ausgebildet sein, insbesondere mit halbkreisförmigen Vertiefungen, und beide Gehäuseteile weisen Kühlrippen auf. Schließlich kann auf den jeweiligen seitlichen Enden eines Gehäuseteiles umlaufend ein Hybridrahmen angeordnet werden, welcher mit Hilfe einer umlaufenden Dichtung gegen die Umwelt abgedichtet ist. Ein Kühlkörper ist beim Gegenstand der DE 198 57 840 A1 nicht vorgesehen.

Ein elektrischer Anschlusskasten in einem Fahrzeug mit einem Wärmeübertragungsrohr ist aus der DE 197 48 286 A1 bekannt. Das Wärmeübertragungsrohr verfügt innerhalb des Anschlusskastens über einen Wärme-Absorptionsabschnitt und außerhalb davon über einen Wärme-Ausstrahlungsabschnitt und ist aus einem elektrisch leitenden Material gebildet. Dadurch wird ein elektrisch leitendes Wärmekollektorglied bereitgestellt, um die von den elektronischen Komponenten erzeugte Wärme zu sammeln, wobei der Wärme-Absorptionsabschnitt des Wärmeübertragungsrohrs mit dem Wärmekollektorglied verbunden ist, und wobei ein Erdungsstrom dem Wärmeübertragungsrohr und dem Wärmekollektorglied zugeführt wird. Das Wärmekollektorglied weist eine Klemme auf, die an einem Erdungsschaltkreis angeschlossen ist und der Wärme-Ausstrahlungsabschnitt des Wärmeübertragungsrohrs ist elektrisch mit einem Montageabschnitt verbunden, an dem der elektrische Anschlusskasten angebracht ist. Das Wärmeübertragungsrohr ist aus einem elektrisch leitenden Material wie beispielsweise Kupfer, einer Kupferlegierung, rostfreiem Stahl oder Aluminium gebildet, und eine Kupferplatte, die sowohl als Kühlkörper als auch als Erdungsplatte dient, wird an dem Wärme-Ausstrahlungsabschnitt angebracht. Der Kühlkörper ist mit einer Mehrzahl von Verbindungsteilen ausgebildet, um den Wärme-Absorptionsabschriitt des Wärmeübertragungsrohrs, das im Anschlusskasten eingefügt ist, an einer seiner langen Seiten und eine Erdungsklemme an einer seiner kurzen Seiten zu befestigen.

Um die Wärmeableitung aus dem Gehäuseinneren zu optimieren und gleichzeitig den technologischen Aufwand für die Herstellung der Gehäuse und der wärmeleitenden Bauteile zu minimieren, ist aus der DE 100 65 857 A1 ein Kunststoffgehäuse bekannt, bei dem eine Wärmeableitung aus dem Gehäuseinneren nach außen oder eine Wärmespreizung innerhalb des Gehäuses dadurch erfolgt, dass eine Gehäusewand mindestens einen Bereich erhöhter thermischer Leitfähigkeit aufweist, indem dieser als eine Komponente aus einem wärmeleitenden Kunststoff beim Mehrkomponentenspritzgießen öder durch Umgießen eines Inserts aus einem wärmeleitenden Kunststoff oder aus Metall hergestellt ist. Im Einzelnen können zur Steigerung der thermischen Leitfähigkeit Kunststoffe mit Metall- oder Keramikpulvern compoundiert werden. In den Fällen, wo bei Verwendung von Metallpulver die erhöhte elektrische Leitfähigkeit des Kunststoffes unerwünscht ist, können keramische Füllstoffen wie Silikatoxid, Aluminiunioxid oder Berylliumoxid benutzt werden. Gezielt eingebrachte Anisotropien der Wärmeleitfähigkeit mit einer Vorzugsrichtung, z. B. durch faserförmige Füllstoffe, dienen dazu die Wärme gerichtet durch das Bauteil abzuleiten. Alternativ dazu ist es möglich, nur mit einer Spritzgusskomponente zu arbeiten und vorgefertigte Inserts aus thermisch leitfähigem Kunststoff oder aus Keramik oder Metall, z. B. Magnesium oder Aluminium, in den Kunststoff einzubringen. Schließlich ist es auch möglich, dass der Bereich erhöhter thermischer Leitfähigkeit in Verbindung mit einer elektronischen Baugruppe steht und durch ein Widerstandsheizelement beheizt ist, um gezielt Wärme zu erzeugen.

Wie die vorstehende Würdigung des Standes der Technik aufzeigt, ist es für unterschiedliche Anwendungsfälle an sich bekannt, die im Gehäuseinneren entstehende Wärme durch Wärmeleitung möglichst direkt nach außen abzuführen, indem der Kühlkörper entweder Gehäusewandungen ausbildet oder mindestens ein Wärmeleitsteg am Kühlkörper angeformt ist oder indem das Gehäuse aus wärmeleitenden Kunststoff besteht oder indem ein Insert aus einem wärmeleitenden Kunststoff oder aus Metall vorgesehen ist, d.h. es wurde stets die Wärmeleitung optimiert. Wie die beiden Druckschriften DE 100 14 457 A1 und DE 199 29 209 A1 aufzeigen, ist es an sich bekannt, einen zusätzlichen Wärmeübergang vom Kühlkörper in eine im Gehäuse eingefüllte Kunststoffmasse zu schaffen. Nachteilig hierbei ist jedoch, dass nicht nur dieser zusätzliche Wärmeübergang einen hohen Herstellungsaufwand und Materialverbrauch erfordert, sondern auch, dass nur mit hohem Aufwand eine Reparatur oder Überprüfung der von der Kunststoffmasse eingehüllten elektrischen/elektronischen Schaltung vorgenommen werden kann. Deshalb fehlt in der Praxis ein Gehäuse mit zwei Gehäuse-Kunststoffschalen und einem im Gehäuse angeordneten Kühlkörper, welches kostengünstig herstellbar, einfach montierbar und vollautomatisch herstellbar ist und welches eine besonders effektive Wärmeabfuhr gewährleistet. Besonders bedeutsam ist dies, weil die Investitionsgüter herstellende Industrie als äußerst fortschrittliche, entwicklungsfreudige Industrie anzusehen sind, die sehr schnell Verbesserungen und Vereinfachungen aufgreift und in die Tat umsetzt.

Der Erfindung liegt gegenüber den bekannten Gehäusen und Verfahren zur Wärmeableitung mittels Kühlkörper die Aufgabe zugrunde, ein solches Gehäuse/Gerät zur Verfügung zu stellen, welches kostengünstig herstellbar ist, welches eine besonders effektive Wärmeabfuhr gewährleistet und welches stabil und robust, insbesondere trittfest und gegen Umwelteinflüssen ausgelegt ist. Diese Aufgabe wird erfindungsgemäß bei einem Gehäuse mit zwei Gehäuse-Kunststoffschalen und mit einem Kühlkörper, gemäß Patentanspruch 1 dadurch gelöst, dass mindestens eine der beiden Gehäuseschalen ein nach außen gerichtetes Profil aufweist und dass ein im Gehäuse angeordneter winkelförmiger Kühlkörper mit einer der beiden Gehäuseschalen durch vollständiges Umspritzen eines Schenkel des Winkels des Kühlkörpers fest verbunden ist und welcher einen nicht umspritzten Schenkel des Winkels als Bauelemente-Montagefläche aufweist, wodurch für die dort montierten Bauelemente das profilierte Gehäuse als Wärmesenke wirkt und insgesamt das Verhältnis von Wärmeübergangswert zu Wärmedurchgangswert optimiert ist.

Die Ausbreitung von Wärme erfolgt durch Wärmestrahlung, Wärmeleitung und Wärmeströmung (Konvektion).

Wärmestrahlung ermöglicht auch die Abgabe von Wärme in das Vakuum, sie ist nur von der Temperatur des strahlenden Körpers abhängig und unabhängig von der Temperatur der Umgebung. Die Wärmestrahlung hängt von der Temperatur des Strahlers/Körpers und auch von der Beschaffenheit seiner Oberfläche ab. Wärmestrahlung erfolgt im Gegensatz zur Wärmeleitung auch dann, wenn der Körper die gleiche Temperatur hat wie seine Umgebung. Wie viel ein Körper abstrahlt, ist unabhängig von der Temperatur seiner Umgebung und der Körper erhält immer Strahlung von seiner Umgebung, selbst wenn diese kälter ist. Allerdings strahlt dann die Umgebung dem Körper weniger zu als umgekehrt und der Körper kühlt sich ab. Die Ausstrahlung eines Körpers wird durch seine spezifische Ausstrahlung beschrieben, wobei je größer der Absorptionsgrad eines Körpers, d.h. das Verhältnis der absorbierten zur auffallenden Strahlung,
desto größer ist seine spezifische Ausstrahlung. So ist die spezifische Ausstrahlung einer blanken Fläche bei gleicher Temperatur kleiner als die einer schwarzen Fläche oder die einer hochglänzend polierten Fläche kleiner als die einer aufgerauten Fläche, wobei die Verhältnisse der spezifischen Ausstrahlung zum Absorptionsgrad von blanker und schwarzer Fläche einander gleich sind. Körper, die den Absorptionsgrad 1 besitzen, die also alle auffallende Strahlung absorbieren und vollständig in Wärme umwandeln, bezeichnet man als absolut schwarze Körper.

Die Wärmeleitung erfolgt nur in der Materie, d.h. im Körper, und setzt in ihm ein Temperaturgefälle voraus. Wenn man einem Körper nicht an einer Stelle dauernd Wärme zuführt oder entnimmt, so gleichen sich alle Temperaturunterschiede in ihm mit der Zeit aus, und zwar durch einen Wärmestrom, der von höherer zu tieferer Temperatur fließt. Metalle sind relativ gute Wärmeleiter, beispielsweise Kupfer mit einer Wärmeleitfähigkeit von 0,93 cal/cm · s · k im Temperaturbereich zwischen 0° C und 100° C oder Aluminium mit einer Wärmeleitfähigkeit von 0,55 cal/cm · s · k im Temperaturbereich zwischen 0° C und 200° C, während Kunststoffe in der Regel schlechtere Wärmeleiter sind. Der Wärmeübergang von einem Körper einer bestimmten Temperatur zu seiner Umgebung wird durch den Wärmeübergangswert beschrieben und der Wärmedurchgang durch einen Körper, beispielsweise eine Platte, beschreibt man durch den Wärmedurchgangswert. Der Wärmeübergangswert hängt, wie bereits vorstehend beschrieben, stark von der Oberflächenbeschaffenheit ab und der Wärmedurchgangswert von der Plattendicke.

Das profilierte Gehäuse gemäß der Erfindung weist den Vorteil auf, dass auf überraschend einfache und kostengünstige Art und Weise das Verhältnis von Wärmeübergangswert zu Wärmedurchgangswert (durch Umspritzen eines Teils des Kühlkörpers und Wärmekapazität des Kunststoffgehäuses) derart optimiert wurde, dass eine besonders effektive Wärmeabfuhr gewährleistet ist. Weiterhin weist das erfindungsgemäße Gehäuse den Vorteil auf, dass ein guter Schutz der im Gehäuse befindlichen Bauelemente vor äußeren Einflüssen bewirkt wird. Schließlich ist auf überraschend einfache Art und Weise das Gehäuse stabil und robust ausgelegt werden (trittfest und gegen Umwelteinflüssen), da das Kühl-/Trag-Profil (in Verbindung mit dem Kühlkörper) sowohl die Stabilität als auch die Wärmestrahlung des Gehäuses erhöht und blanke Teile des Kühlkörpers nicht der Umwelt ausgesetzt sind.

Weiterhin wird diese Aufgabe bei einem Verfahren zur Herstellung des Gehäuses nach Patentanspruch 9, dadurch gelöst, dass bei der Fertigung der Kühlkörper direkt mit ins Gehäuse eingespritzt wird, wobei zum Toleranzausgleich als Distanzhalter für den Kühlkörper dienende Noppen am Werkzeug verwendet werden und dadurch die Toleranzschwankungen des Kühlkörpers direkt in die Wanddicke des Gehäuses eingehen.

Das erfindungsgemäße Verfahren weist den Vorteil auf, dass erstmalig keine Frästeile als Kühlkörper notwendig werden, wobei auch hohe Ansprüche an eine Abdichtung erfüllt werden und das Gehäuse ist infolge der wenigen zusammenzufügenden Teile vollautomatisch herstellbar. Im Vergleich zum Stand der Technik ist der Kühlkörper nicht Umwelteinflüssen ausgesetzt, verstärkt auf einfache Art und Weise die Stabilität des Gehäuses und optimiert das Verhältnis von Wärmeübergangswert zu Wärmedurchgangswert.

In Weiterbildung der Erfindung ist, gemäß Patentanspruch 2, der Kühlkörper L-förmig ausgestaltet und die Kunststoffschale bedeckt einen Schenkel des Kühlkörpers mit Ausnahme einiger dem Innenraum des Gehäuses zugewandter Aussparungen vollständig mit Kunststoff, während der andere Schenkel nicht umspritzt ist.

Diese Weiterbildung der Erfindung weist den Vorteil auf, dass eine besonders einfache Montage der wärmeabgebenden Bauelemente ermöglicht wird. Der Kühlkörper übernimmt dabei eine Doppelfunktion, einerseits zum Tragen der Bauelemente, andererseits zu dessen herstelltechnisch einfacher und unveränderbarer Befestigung unter gleichzeitiger Verbesserung der Wärmeleit- und Wärmeübergangseigenschaften. Weiterhin entsteht einerseits eine absolut dichte Verbindung zwischen Kühlkörper und Gehäuse, andererseits wird eine elektrische Isolierung der Baugruppe gegenüber dem Kühlkörper erreicht und somit Kurzschlüsse zwischen verschiedenen Potentialen verhindert.

Vorzugsweise besteht, gemäß Patentanspruch 3, der Kühlkörper aus einem wärmeleitenden Material und ist ein Druckgussteil oder ein Fließpressteil.

Das vorzugsweise benutzte Aluminium erfüllt höchste Ansprüche hinsichtlich Resistenz gegenüber Schadstoffen und Korrosion bei gleichzeitig guter Wärmeleitung und gutem Wärmeübergang nach dem Umspritzen.

In Weiterbildung der Erfindung sind, gemäß Patentanspruch 4, als Profil sowohl an der Gehäuse-Oberseite als auch an der Gehäuse-Unterseite Kühl-/Tragrippen vorgesehen.

Mit dieser Weiterbildung der Erfindung kann auf überraschend einfache Art und Weise das Gehäuse besonders stabil und robust ausgelegt (trittfest) und die Wärmestrahlung durch Wahl des Profils, (z.B. dreieckförmig, trapezförmig) einschließlich unterschiedlicher Stufung des Profils in Teilbereichen, weiter verbessert werden.

Bei einer bevorzugten Ausgestaltung der Erfindung sind, gemäß Patentanspruch 5, die Bauelemente durch Haltemittel an dem Kühlkörper befestigt und die darüber befindliche Kunststoffschale weist angeformte Ansätze zum Niederhalten der Haltemittel auf.

Diese Ausgestaltung der Erfindung weist den Vorteil auf, dass in Doppelfunktion auf vorteilhafte Art und Weise ein zusätzlicher Wärmeübergang zwischen den angeformten Ansätzen und den Haltemittel/Bauelementen geschaffen und auch eine rüttelfeste Befestigung der Bauelemente sichergestellt wird. Die Haltemittel können vorzugsweise Clipse sein, wie diese ansich aus dem G 88 12 158.5 bekannt sind. Die daraus bekannte Befestigungsklammer ist an ihrem einen Ende U-förmig umgebogen und weist in ihrem mittleren Bereich einen abgekröpften Steg auf. An ihrem anderen Ende ist diese zur Bildung einer definierten Auflagefläche hakenförmig abgewinkelt. Der Kühlkörper weist eine Nase zur Aufnahme des U-förmig umgebogenen Endbereichs der Befestigungsklammer auf, was eine Befestigung des Transistors auf dem Kühlkörper mittels eines einzigen Handgriffs erlaubt. Die erfindungsgemäßen Clipse können durch die Kombination mit den Ansätzen zum Niederhalten der Clipse im Vergleich hierzu noch einfacher ausgestaltet werden und ermöglichen eine vollautomatische Bestückung mit handelsüblichen Bestückungsautomaten durch die gute Zugänglichkeit der Bauelemente-Montagefläche.

Weiterhin ist, gemäß Patentanspruch 6, in mindestens einer Seitenwand der Kunststoffschale mindestens eine Kabelverschraubung und in einer der Kunststoffschalen sind Mittel zur Befestigung einer Leiterplatte eingeformt.

Durch die Verwendung von Kunststoff sind der Gestaltungsmöglichkeit bei hermetischer Abdichtung des Gehäuses keine Grenzen gesetzt. Gleiches gilt für die Ausgestaltungen nach den Patentansprüchen 7 und 8, welche kostengünstig hinsichtlich Dichtigkeit einschließlich Abschirmung herstellbar sind,

Weitere Vorteile und Einzelheiten lassen sich der nachfolgenden Beschreibung einer bevorzugten Ausführungsform der Erfindung unter Bezugnahme auf die Zeichnung entnehmen. In der Zeichnung zeigt:
- FIG. 1: eine Ausführungsform des erfindungsgemäßen Gehäuses ohne Befestigungsmittel für den Einbau des Gehäuses in perspektivischer Ansicht,
- FIG. 2a: das Gehäuse nach FIG. 1 in Seitenansicht, teilweise im Schnitt und
- FIG. 2b: das Gehäuse nach FIG. 2a geöffnet und in Draufsicht,
- FIG. 3a: eine Ausführungsform der erfindungsgemäßen oberen Gehäuse-Kunststoffschalen in Draufsicht und
- FIG. 3b, 3c: die obere Gehäuse-Kunststoffschale nach FIG. 3a in Seitenansicht,
- FIG. 4a, 4b: eine Ausführungsform der erfindungsgemäßen unteren Gehäuse-Kunststoffschalen in Seitenansicht und
- FIG. 4c, 4d: die untere Gehäuse-Kunststoffschale nach FIG. 4a, 4b in Draufsicht und Seitenansicht, teilweise im Schnitt,
- FIG. 5a, 5b: eine Ausführungsform der Leiterplatte in Seitenansicht und in Draufsicht und
- FIG. 6a, 6c: eine Ausführungsform des erfindungsgemäßen Kühlkörpers in Seitenansicht und
- FIG. 6b: den Kühlkörper nach FIG. 6a, 6c in Draufsicht.

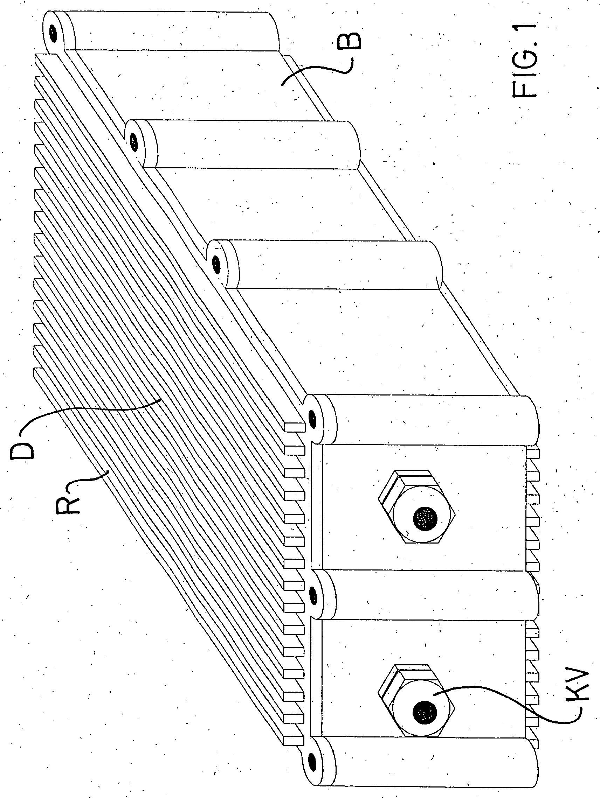

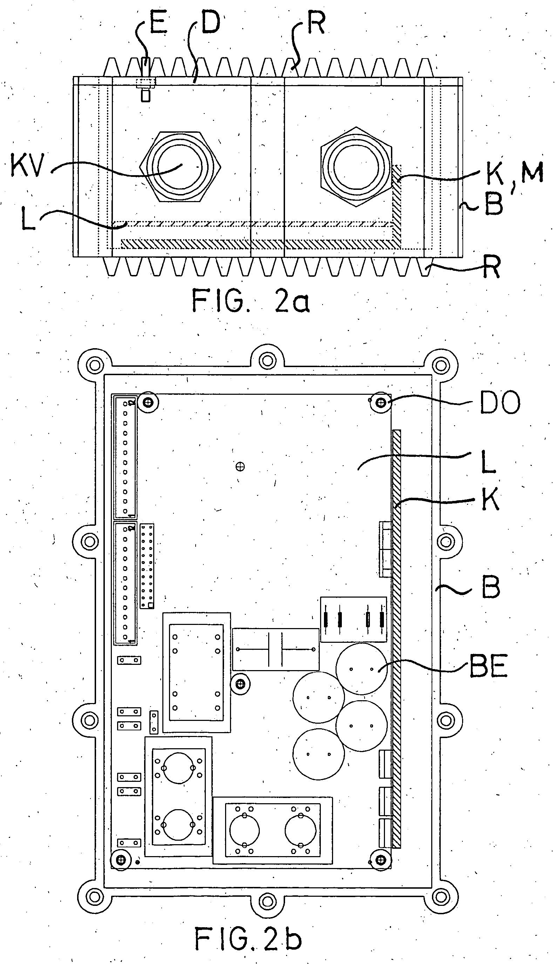

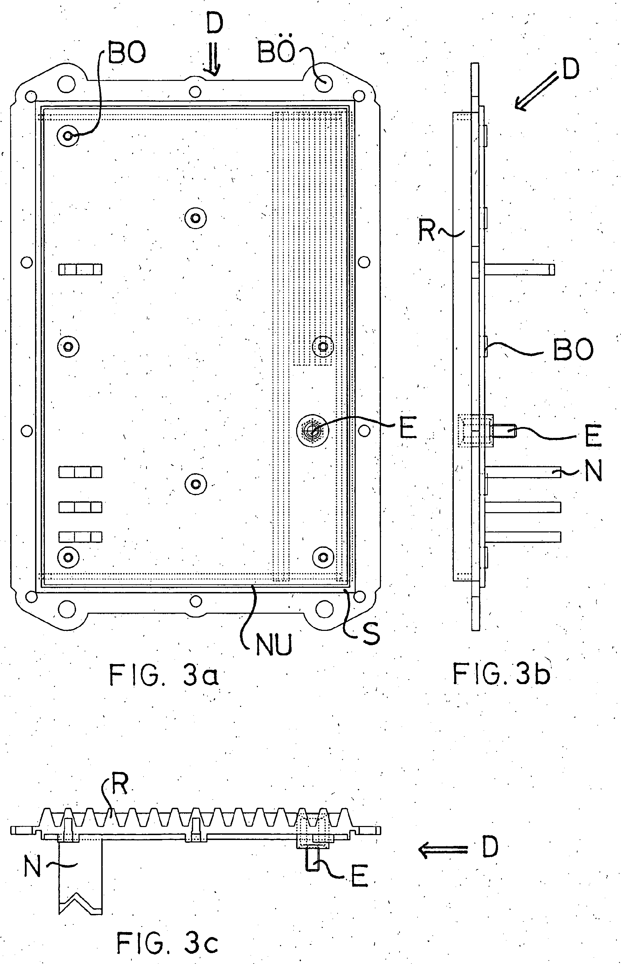

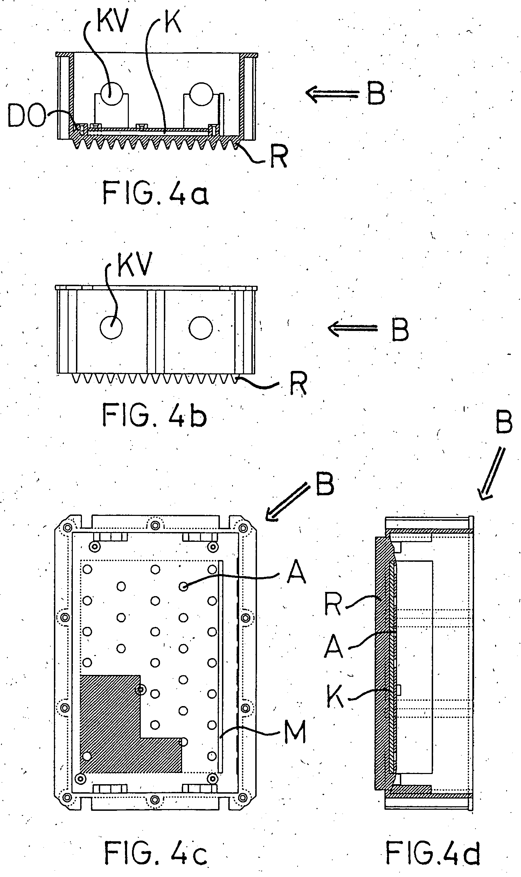

FIG. 1 bis FIG. 6c zeigen im Detail das erfindungsgemäße Gehäuse mit einer Baugruppe, welche zur Steuerung/Überwachung der Befeuerung eines Flughafens eingesetzt wird. Die Baugruppe/Modul besteht aus einer Leiterplatte L für die elektronische Schaltung, die in das Gehäuse eingebaut ist.

Da die erfindungsgemäßen Gehäuse auf dem Flugfeld in Kabelschächten (auch unter Wasser) installiert werden, werden besondere Ansprüchen an die Dichtigkeit des Gehäuses gestellt. Die Schächte sind nicht klimatisiert und so unterliegt die Baugruppe/Modul extremen Temperaturschwankungen. Die Temperaturen können zwischen etwa -25°C bis +65°C schwanken, wobei die Baugruppe/Modul in allen Temperaturbereichen voll funktionsfähig sein muss. Die Schnittstellen sind durch Leitungen realisiert, die aus dem Gehäuse ragen, wobei die Leitungslänge jeweils ca. 0,5m beträgt. Da das Gehäuse wasserdicht sein soll (IP 68, d.h. wasserdicht bis zu einem Druck entsprechend 2m Wassersäule), muss es auch korrosionsfrei sein. Infolgedessen, dass auf Flughäfen zur Enteisung der Rollbahn bzw. zum Abtauen aggressive Taumittel eingesetzt werden und auch Treibstoff in die Schächte läuft, muss das Gehäuse säurefest sein. Es weist weiterhin eine Resistenz gegen Schadstoffe auf wie:
- Salzwasser (Meerwasser)
- Kraftstoffe (auch Kerosin, Flugbenzin)
- Flusswasser
- Luft (salzhaltig)
- Glysantin (max. 50%-ige Lösung in Wasser).

Weiterhin darf das Gehäuse nicht elektrisch leitfähig und nicht brennbar sein. Zudem ist die mechanische Belastbarkeit zu beachten, d.h. das Gehäuse muss stabil und robust ausgelegt sein (trittfest). Da die Installation der erfindungsgemäßen Gehäuse sich unter der Erde befindet, müssen die Gehäuse nagetierfest sein. Um die im Inneren der Gehäuse entstehende Temperatur (ca. 20W Verlustleistung) möglichst gut ableiten zu können, soll der verwendete Kunststoff gute Wärmeleitfähigkeit besitzen.

Zur Erfüllung vorstehender Anforderungen weist das erfindungsgemäße Gehäuse zwei Gehäuse-Kunststoffschalen B, D und einen im Gehäuse B, D angeordneten Kühlkörper K auf. Die Innenmaße des Gehäuse betragen ca. 117mm · 184mm · 58,6mm (Breite · Länge · Höhe). Die Außenmaße ergeben sich aus den Innenmaßen und den Wandstärken (3mm). Innerhalb des Gehäuses B, D entsteht im wesentlichen an zwei Funktionsgruppen Verlustleistung durch die Bauteile der Baugruppe/Modul, nämlich:
- durch den Gleichstromwiderstand der Drosselspulen
- durch Verluste in den Halbleitern für Stromversorgung und Sendeverstärker.

Der Kühlkörper K ist erfindungsgemäß mit einer der beiden Gehäuse-Kunststoffschalen B, D durch vollständiges Umspritzen eines Teils des Kühlkörpers K fest verbunden und weist einen nicht umspritzten Abschnitt als Bauelemente-Montagefläche M auf, wodurch für die dort montierten Bauelemente BE das Gehäuse B, D als Wärmesenke wirkt.

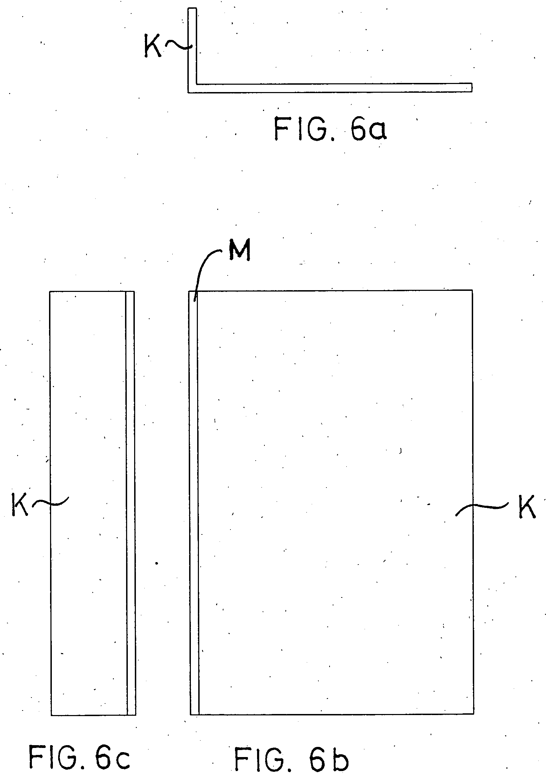

Der Kühlkörper K besteht aus einem wärmeleitenden Material und ist ein Aluminiumdruckgussteil oder ein Aluminiumfließpressteil. Die Bauelemente BE, d.h. die Halbleiter, sind mit Haltemittel, vorzugsweise u-förmige Clipse, an dem Aluminiumwinkel, der als Kühlkörper K dient, befestigt. Dieser Winkel K ist direkt in die Kunststoffschale B, d.h. in das Unterteil des Kunststoffgehäuses, mit eingespritzt und auf der Oberseite (zwischen Gehäuse und Baugruppe), mit Ausnahme einiger Aussparungen A zur Aufnahme in der Form (Negativ zu den Noppen am Werkzeug, an denen der Winkel K durch einen Schieber beim Spritzvorgang angepresst wird; Toleranzausgleich) und zur Optimierung der Wärmestrahlung, komplett mit Kunststoff bedeckt. Hierdurch lässt sich einerseits ein optimaler Wärmeübergang vom Aluminium zum Kunststoff und andererseits eine elektrische Isolierung der Baugruppe gegenüber dem Aluminiumwinkel K, und somit Verhinderung von Kurzschlüssen zwischen verschiedenen Potentialen, erreichen. Das L-Profil (siehe FIG. 6a, FIG. 6b und FIG. 6c) hat beispielsweise die Maße 100mm · 150mm · 30mm · 3mm (Breite · Länge · Höhe · Dicke).

Kühl-/Tragrippen R sowohl an der Gehäuse-Oberseite als auch an der Gehäuse-Unterseite vergrößern die Oberfläche und verbessern damit sowohl die Wärmeabfuhr als auch die Stabilität. Eine keil- oder trapezförmige Ausbildung der Rippen R, welche ca. 7mm hoch sind, verringert zwar die Oberfläche etwas, das Entstehen von Verwirbelungen wird aber reduziert, wodurch sich die Wärmeabstrahlung wieder verbessert.

Zur Befestigung der Baugruppe/Leiterplatte L sind im Gehäuse-Unterteil B entsprechende Mittel DO, vorzugsweise Dome, vorgesehen. In diesen Domen DO lässt sich die Baugruppe/Leiterplatte L mittels selbstschneidenden Schrauben befestigen, wobei gleichzeitig ein ausreichender Abstand zwischen Leiterplatte L und Gehäuse-Unterteil B gewährleistet ist.

Zur Verbesserung des EMV-Verhaltens (sowohl Ein- als auch Abstrahlung) kann das Gehäuse-Unterteil B von innen elektrisch leitfähig beschichtet sein. Hierbei ist der Bereich unter der Baugruppe/Leiterplatte L ausgespart, um Kurzschlüsse zu verhindern. Die Abschirmung unter der Leiterplatte L ist durch den eingespritzten Kühlkörper K realisiert. Weiterhin sind im Gehäuse-Oberteil D mehrere Bohrungen BO vorgesehen, in denen ein Blech zur elektromagnetischen Abschirmung mit selbstschneidenden Schrauben befestigt werden kann. Die Bohrungen in Ober- und Unterteil D, B sind so gestaltet, dass nur eine Schraubensorte erforderlich ist.

Im Gehäuse-Oberteil D sind Niederhalter N integriert, die verhindern, dass sich die Clipse, mit denen die Halbleiter BE am Kühlkörper K befestigt sind, z.B. durch Vibration lösen können.

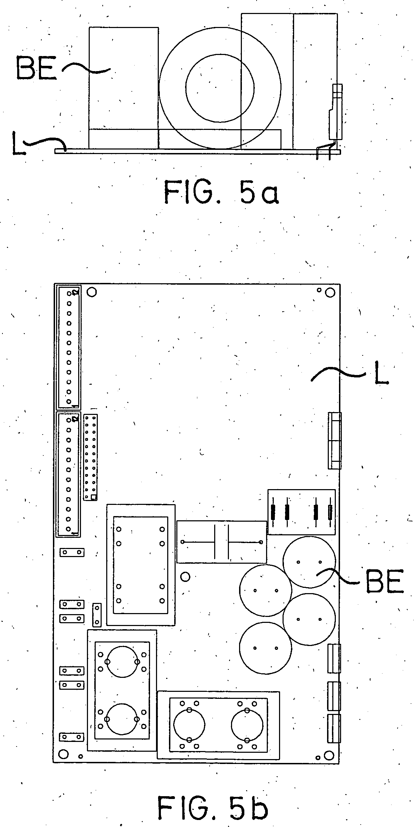

Zur Ableitung von Überspannungen, die z.B. durch Blitzschlag über die Leitungen auf die Baugruppe/Leiterplatte L geführt werden, ist eine Erdung notwendig. Hierfür ist im Gehäuse-Oberteil D ein Gewindebolzen E eingespritzt oder von innen eingepresst, an dem von der Innenseite ein Kabel zur Leiterplatte L führt. Im zuletzt genannten Fall ist auch eine Dichtung vorzusehen, damit die Wasserdichtigkeit gewährleistet ist. An der Außenseite kann ein Erdungskabel verschraubt werden. Die Leiterplatte L (siehe FIG. 5a und FIG. 5b) hat beispielsweise etwa die Maße 100mm · 170mm · 1,6mm (Breite · Länge · Dicke). Die Bauteile/Bauelemente BE auf der Oberseite haben eine maximale Höhe von ca. 48mm, auf der Unterseite ca. 2,5mm. Die Befestigung der Leiterplatte L erfolgt mittels mehrerer Schrauben im Gehäuse. Hierzu befinden sich Bohrungen (ca. 3mm Durchmesser) in den Ecken der Leiterplatte. Es können selbstschneidende Schrauben zum Einsatz kommen.

Im Gehäuse-Oberteil D ist innen umlaufend ein Steg S eingearbeitet. Dieser Steg S justiert das Gehäuse-Oberteil D während der Montage auf dem Gehäuse-Unterteil B, so dass es nicht verrutschen kann. Dies vereinfacht die Montage und stellt bei Passgenauigkeit eine gute Dichtheit sicher. Weiterhin besitzt das Gehäuse-Oberteil D am Rand innen eine umlaufende Nut NU, in die Dichtungsmasse direkt eingespritzt ist. Dadurch ist keine separate Form für einen Dichtungsring erforderlich. Weiterhin kann bei der Montage kein Dichtungsring verrutschen. Auch die verwendete Dichtungsmasse muss resistent gegen die oben erwähnten Schadstoffe sein.

Die Kabel sind durch metrische Kabelverschraubungen KV, beispielweise M20 x 1,5, ins Gehäuse geführt. Hierzu sind auf den beiden schmalen Seiten je zwei Bohrungen vorzusehen, die ein entsprechendes Gewinde besitzen. Die zwei Bohrungen auf der rechten Seite sind optional und sind in der Regel geschlossen, lassen sich aber bei Bedarf leicht ausbrechen. Falls erforderlich, können bei der Verschraubung KV Dichtungsringe zum Einsatz kommen, um die geforderte Dichtigkeit zu erreichen. Auch die verwendeten Dichtungen müssen resistent gegen die oben erwähnten Schadstoffe sein.

Die beiden Gehäuseteile B, D sind mit mehreren beispielsweise selbstschneidenden Schrauben (ca. 4mm Gewindedurchmesser) miteinander zu verbinden. Im Gehäuse-Oberteil D ist in den Ecken je eine Befestigungsöse BÖ eingearbeitet. Das Gehäuse B, D kann also liegend oder auch in beliebiger Lage hängend eingebaut sein.

Das erfindungsgemäße Gehäuse gewährleistet eine einfache, funktionale, kostensparende und damit eine optimale Verwendbarkeit und reduziert damit ganz erheblich die Herstellungskosten. Der Kühlkörper K ist direkt in den Kunststoff des Gehäuseteils B eingegossen, wodurch jeweils im Verhältnis optimiert zueinander ein guter Wärmeübergang vom Kühlkörper K in das Gehäuse B, D, ein guter Wärmedurchgang und eine gute Wärmestrahlung erreicht wird: Weitere Vorteile sind: die elektrische Isolation zwischen Kühlkörper K und Bauteilen/Bauelementen BE; die einfach zu montierende Befestigung der Halbleiter BE am Kühlkörper K mittels Clipse, wodurch keine Verschraubung nötig ist und eine zusätzliche Kühlleistung der Clipse realisiert ist; die Integration der Niederhalter N im Gehäuseoberteil D, wodurch verhindert wird, dass sich die Clipse zur Befestigung der Halbleiter BE am Kühlkörper K beispielsweise durch Vibration lösen; die Ableitung von Überspannungen (Blitzschutz) durch die Erdungsdurchgangsschraube E im Gehäuseoberteil D; die größere Fläche bewirkt eine größere Kühlleistung durch die trapezförmige Außenfläche/Rippen R des Gehäuses B, D.

Fertigungstechnische Vorteile ergeben sich dadurch, dass der Kühlkörper K bei der Fertigung direkt mit ins Gehäuse-Unterteil B oder ins Gehäuse-Oberteil D eingespritzt wird. Dabei wird der Kühlkörper K auf Noppen als Distanzhalter am Werkzeug aufgelegt und Toleranzschwankungen des Aluminiums gehen direkt in die Wanddicke des Gehäuses ein, wenn der Schieber den Winkel K beim Spritzvorgang anpresst (d.h. Toleranzschwankungen werden dadurch kompensiert). Die Noppen am Werkzeug (das Negativ hierzu sind die Aussparungen A) können eine beliebige Form, beispielsweise dreieckig, kreisförmig usw. und Größe sowie Dichte der Verteilung aufweisen, wobei die Schwächung der Stabilität durch den Kühlkörper K und durch das profilierte Kunststoffgehäuse B, D mehr als kompensiert wird. Weiterhin ergibt sich ein Kostenvorteil dadurch, dass keine Frästeile für den Kühlkörper K notwendig sind und durch die nach innen hin offenen Flächen des Kühlkörpers K (Aussparungen A) das Verhältnis von Wärmeübergangswert zu Wärmedurchgangswert weiter optimiert wird. Schließlich kann ein handelsüblicher Spritzautomat benutzt werden und sowohl die Fertigung des profilierten Gehäuses gemäß der Erfindung als auch dessen Bestückung kann ebenfalls vollautomatisch erfolgt, indem in das vorgefertigte Gehäuse-Unterteil B die bestückte Leiterplatte L eingesetzt, befestigt und dann das Gehäuse-Oberteil D aufgesetzt und befestigt wird.

Das erfindungsgemäße trittfeste, wärmeableitende und -abstrahlende Kunststoffgehäuse mit Kühl-/Tragrippen und teilweise umspritztem, ins Gehäuseinnere ragendem Kühlkörper findet überall dort Anwendung, wo hohe Ansprüche an Dichtfähigkeit, Robustheit (einschließlich gegen Umwelteinflüssen) und ein Höchstmaß an effizienter Wärmeabführung gestellt werden, beispielsweise im Automobilbau, Schiffbau, Containerbau, Carawanbau, Fassadenbau, Silotechnik, Kälte- und Klimatechnik und Gerätebau für Telekommunikationstechnik und der industriellen Elektronik.

Alle dargestellten und beschriebenen Ausführungsmöglichkeiten, sowie alle in der Beschreibung und/oder der Zeichnung, offenbarten neuen Einzelmerkmale und ihre Kombination untereinander, sind erfindungswesentlich. Beispielsweise können die Stecker direkt ins Gehäuse (B und/oder D) eingeschraubt sein, wobei auch diese Verbindung und die Stecker selbst wasserdicht sind; die Baugruppe/Modul/Leiterplatte L kann vergossen sein, um unanfälliger gegenüber Umwelteinflüssen zu sein, wobei auch hier die Wärmeabfuhr nicht beeinträchtigt ist; es können Rastelemente vorsehen werden, mit denen beispielsweise die Leiterplatte L in dem Gehäuse (vorzugsweise in B) klemmend befestigt wird; es können weiterhin Hinterschneidungen oder andere Rastelemente am Gehäuse-Unterteil B vorgesehen werden, die beispielsweise dann das Gehäuse-Oberteil D halten; zur Verbesserung der Dichtigkeit am Gehäuse-Unterteil B die Auflagefläche (umgebogener Rand) verbreitert und darin eine Nut für eine weitere Dichtung vorgesehen werden usw.

## Patentansprüche

1. Gehäuse mit zwei Gehäuse-Kunststoffschalen (B, D) und mit einem Kühlkörper (K), wobei mindestens eine der beiden Gehäuseschalen (B, D) ein nach außen gerichtetes Profil (R) aufweist und dass ein im Gehäuse (B, D) angeordneter winkelförmiger Kühlkörper (K) mit einer der beiden Gehäuseschalen (B, D) durch vollständiges Umspritzen eines Schenkel des Winkels des Kühlkörpers (K) fest verbunden ist und welcher einen nicht umspritzten Schenkel des Winkels als Bauelemente-Montagefläche (M) aufweist, wodurch für die dort montierten Bauelemente (BE) das profilierte Gehäuse (B, D) als Wärmesenke wirkt und insgesamt das Verhältnis von Wärmeübergangswert zu Wärmedurchgangswert optimiert ist.

2. Gehäuse nach Anspruch 1, **dadurch gekennzeichnet, dass** der Kühlkörper (K) L-förmig ausgestaltet ist und dass die Kunststoffschale (B) einen Schenkel des Kühlkörpers (K) mit Ausnahme einiger dem Innenraum des Gehäuses (B, D) zugewandter Aussparungen (A) vollständig mit Kunststoff bedeckt, während der andere Schenkel nicht umspritzt ist.

3. Gehäuse nach Anspruch 2, **dadurch gekennzeichnet, dass** der Kühlkörper (K) aus einem wärmeleitenden Material besteht und dass der Kühlkörper (K) ein Druckgussteil oder ein Fließpressteil ist

4. Gehäuse nach Anspruch1, **dadurch gekennzeichnet, dass** als Profil (R) sowohl an der Gehäuse-Oberseite als auch an der Gehäuse-Unterseite Kühl-/Tragrippen (R) vorgesehen sind.

5. Gehäuse nach Anspruch 1, **dadurch gekennzeichnet, dass** die Bauelemente (BE) durch Haltemittel an dem Kühlkörper (K) befestigt sind und dass die darüber befindliche Kunststoffschale (D) angeformte Ansätze (N) zum Niederhalten der Haltemittel aufweist.

6. Gehäuse nach Anspruch 1, **dadurch gekennzeichnet, dass** in mindestens einer Seitenwand der Kunststoffschale (B) mindestens eine Kabelverschraubung (KV) und in einer der Kunststoffschalen (B) Mittel (DO) zur Befestigung einer Leiterplatte (L) eingeformt sind.

7. Gehäuse nach Anspruch 1 oder 6, **dadurch gekennzeichnet, dass** in mindestens einer der Kunststoffschalen (B oder D) ein Gewindebolzen (E) zur Erdung eingespritzt ist, an dem von der Innenseite ein Kabel zur Leiterplatte (L) angeschlossen ist und dass an einer der Kunststoffschalen (D oder B) außen mindestens ein Befestigungsanschluss (BÖ) angeformt ist.

8. Gehäuse nach Anspruch 1, **dadurch gekennzeichnet, dass** eine der beiden Kunststoffschalen (B, D) einen innen umlaufenden Steg (S) und/oder eine innen umlaufende Nut (NU) aufweist und dass die Kunststoffschalen (B, D) innen metallisiert sind oder Aufnahmen (BO) für ein Abschirmblech angeformt sind.

9. Verfahren zur Herstellung des Gehäuses nach Anspruch 1, wobei bei der Fertigung der Kühlkörper (K) direkt mit Gehäuse ins Gehäuse (B, D) eingespritzt wird, wobei zum Toleranzausgleich als Distanzhalter für den Kühlkörper (K) dienende Noppen am Werkzeug verwendet werden und dadurch die Toleranzschwankungen des Kühlkörpers (K) direkt in die Wanddicke des Gehäuses (B, D) eingehen.

10. Verfahren nach Anspruch 9, **dadurch gekennzeichnet, dass** beim Umspritzprozess eines L-förmigen Kühlkörpers (K) gleichzeitig Mittel (DO) zur Befestigung einer Leiterplatte (L) im Abstand zum ganz oder teilweise umspritzten Schenkel angeformt werden.

## Claims

1. Housing, comprising two plastic housing shells (B, D) and a cooling body (K), wherein at least one of the two plastic shells (B, D) has an outwardly directed profile (R) and that in the housing (B, D) an angular heat sink (K) is arranged, which is fixedly connected to one of the two housing plastic shells (B, D) by a complete encapsulation of a side of the angle of the heat sink (K) and which has a non-overmolded side of the angle as a component mounting surface (M), whereby for the components (BE) mounted thereon the profiled housing (B, D) acts as a heat sink and overall the ratio of heat transfer value to heat transition value is optimized.

2. Housing according to claim 1, **characterized in that** the cooling body (K) is L-shaped and that the plastic shell (B) completely covered a side of the heat sink (K) with the exception of some facing recesses (A) to the interior of the housing (B, D) with plastic, while the other side is not encapsulated.

3. Housing according to claim 2, **characterized in that** the cooling body (K) consists of a thermally conductive material and that the cooling body (K) is a die-cast part or a flow-pressed part.

4. Housing according to claim 1, **characterized in that** a profile (R) both on the housing top and on the housing bottom cooling / support ribs (R) are provided.

5. Housing according to claim 1, **characterized in that** the components (BE) are fixed by holding means on the heat sink (K) and that the plastic shell located above (D) integrally formed lugs (N) for holding down the holding means.

6. Housing according to claim 1, **characterized in that** in at least one side wall of the plastic shell (B) at least one cable screw fitting (KV) and in one of the plastic shells (B) means (DO) for mounting a printed circuit board (L) are formed.

7. Housing according to claim 1, **characterized in that** in at least one of the plastic shells (B or D), a threaded bolt (E) is injected to ground, to which from the inside a cable to the circuit board (L) is connected and that at one of plastic shells (D or B) at least one mounting connection (BÖ) is formed outside.

8. Housing according to claim 1, **characterized in that** one of the two plastic shells (B, D) has an inner circumferential web (S) and / or an inner circumferential groove (NU) and that the plastic shells (B, D) are metallized inside or recesses (BO) are formed for a shielding plate.

9. A Method for producing the housing according to claim 1, **characterized in that** in the production the heat sink (K) is injected directly into the housing (B, D), nubs on the tool being used for tolerance compensation as a spacer for the heat sink (K) and thereby the tolerance variations of the heat sink (K) go directly into the wall thickness of the housing (B, D).

10. A method according to claim 9, **characterized in that** during the extrusion process of an L-shaped heat sink (K) at the same time means (DO) for mounting a printed circuit board (L) are formed at a distance to the fully or partially overmoulded side.

## Revendications

1. Boîtier comprenant deux coques en plastique (B, D) et un dissipateur thermique (K), à condition que, au moins une des deux coques en plastique (B, D) ayant un profil dirigé vers l'extérieur (R) et que le boîtier (B, D) comporte un drain thermique et de forme angulaire (K), qui est reliée de manière fixe à l'une des deux coques en plastique (B, D) par encapsulation complète d'une partie du dissipateur thermique (K) et comporte une partie non surmoulée comme surface de montage de composant (M) en tant que sur laquelle sont montés des composants (BE) le boîtier profilé (B, D) agit comme un dissipateur thermique et globalement le rapport de la valeur de transfert thermique à la valeur de transmission thermique est optimisé.

2. Boîtier selon la revendication 1, **caractérisé en ce que** le dissipateur thermique (K) est en forme de L et que la coque en plastique (B) une branche du dissipateur thermique (K) à l'exception (A) d'une partie de l'intérieur du boîtier (B, D) est complètement recouvert de plastique, tandis que l'autre branche n'est pas encapsulée.

3. Boîtier selon la revendication 2, **caractérisé en ce que** le dissipateur thermique (K) est constitué d'un matériau thermoconducteur et **en ce que** le dissipateur thermique (K) est une pièce coulée sous pression ou une pièce pressée par écoulement.

4. Boîtier selon la revendication 1, **caractérisé en ce qu'**il est prévu à la fois un profil (R) sur le dessus du boîtier et sur le fond du boîtier, celui est en forme des ailettes de refroidissement ou des nervures porteuses (R).

5. Boîtier selon la revendication 1, **caractérisé en ce que** les composants (BE) par des moyens de maintien sur le dissipateur thermique (K) sont fixes et que la coque en matière plastique située au-dessus (D) forme des ergots (N) pour maintenir les moyens de maintien.

6. Boîtier selon la revendication 1, **caractérisé en ce que** dans au moins une paroi latérale de la coque en plastique (B) sont formés au moins un presse-étoupe (KV) et en un des coques en plastique (B) des moyens (DO) pour le montage d'une carte de circuit sont imprimé.

7. Boîtier selon les revendications 1 ou 6, **caractérisé en ce qu'**au moins une des coques en plastique (B ou D) est reliée à la terre par un boulon fileté (E)
auquel est relié de l'intérieur un câble à la platine (L) et des coques en plastique (D ou B) à l'extérieur d'au moins une connexion de montage (BÖ) est formées.

8. Boîtier selon la revendication 1, **caractérisé en ce que** l'une des deux coques en plastique (B, D) présente une nervure circonférentielle intérieure (S) et / ou une rainure circonférentielle interne (NU) et que les coques en plastique (B, D) sont métallisées à l'intérieur ou logements (BO) pour une plaque de blindage sont formés.

9. Procédé de fabrication du boîtier selon la revendication 1, **caractérisé en ce que** dans la production du dissipateur de chaleur (K) est injecté directement dans le boîtier (B, D), servant de compensation de tolérance en tant qu'un élément d'écartement pour le dissipateur de chaleur (K) et ainsi les variations de tolérance du dissipateur de chaleur (K) vont directement dans l'épaisseur de paroi du boîtier (B, D).

10. Procédé selon la revendication 9, **caractérisé en ce que** pendant le processus d'extrusion d'un dissipateur thermique en forme de L (K), des moyens (DO) de montage d'une carte de circuit imprimé (L) sont formés à distance de la branche entièrement ou partiellement surmoulée.
